# EUROPEAN PATENT SPECIFICATION

(11) **EP 3 628 714 B1**
(45) Date of publication and mention of the grant of the patent: **15.06.2022**
(21) Application number: 19200329.1
(22) Date of filing: 30.09.2019
(51) Int. Cl.: C09G 1/00

(54) **BARRIER SLURRY REMOVAL RATE IMPROVEMENT**
VERBESSERUNG DER BESEITIGUNGSRATE VON BARRIERESCHLAMM
AMÉLIORATION DU TAUX D'ÉLIMINATION DE BOUE D'UNE BARRIÈRE

(30) Priority: 28.09.2018 US 201862738427 P; 20.09.2019 US 201916577580
(43) Date of publication of application: 01.04.2020
(73) Proprietor: Versum Materials US, LLC, Tempe, AZ 85284 (US)
(72) Inventor: GAN, Lu, Tempe, Arizona 85284 (US); SCHLUETER, James Allen, Tempe, Arizona 85284 (US)
(74) Representative: Beck Greener LLP

(56) References cited:
- EP-A1- 3 153 558
- EP-A2- 1 936 674
- WO-A2-2006/133249
- US-A1- 2005 211 953

## Description

### BACKGROUND OF THE INVENTION

The present invention relates to barrier chemical mechanical planarization ("CMP") polishing composition (or slurry) used in the production of a semiconductor device, and polishing methods for carrying out chemical mechanical planarization. In particular, it relates to barrier polishing compositions that are suitably used for polishing patterned semiconductor wafers that are composed of multi-type films, for instances, metal layer, a barrier film, and an underlying interlayer dielectric (ILD) structure or patterned dielectric layer.

Usually, a barrier layer covers the patterned dielectric layer and a metal layer covers the barrier layer. The metal layer has at least sufficient thickness to fill the patterned trenches with metal to form circuit interconnects.

A barrier typically is a metal, metal alloy or intermetallic compound, examples are Ta or Ti containing film, such as Ta, TaN, Ti, TiN, or TiW, or et al. The barrier forms a layer that prevents migration or diffusion between layers within a wafer. For example, barriers prevent the diffusion of interconnect metal such as copper or cobalt into an adjacent dielectric. Barrier materials must be resistant to corrosion by most acids, and thereby, resist dissolution in a fluid polishing composition for CMP. Furthermore, these barrier materials may exhibit a toughness that resists removal by abrasion abrasive particles in a CMP composition and from fixed abrasive pads.

In relation to CMP, the current state of this technology involves the use of a multi-step such as, for example, a two-step process to achieve local and global planarization.

During step one of a typical CMP process, a metal layer such as an overburdened copper layer is typically removed, while leaving a smooth planar surface on the wafer with metal-filled lines, vias and trenches that provide circuit interconnects planar to the polished surface. Thus, Step 1 tends to remove excess interconnect metals, such as copper. Then step two of a typical CMP process, frequently referred to as a barrier CMP process, follows to remove the excess metal layers and the barrier layer and other films on the surface of the patterned wafers to achieve both local and global planarization of the surface on the dielectric layer.

US Patent US 7,491,252 B2 discloses a chemical mechanical planarization solution for removing tantalum barrier materials. The solution includes nonferrous metal and 0 to 20 complexing agent for the non-ferrous metal, 0.01 to 12 tantalum removal agent selected from the group consisting of formamidine, formamidine salts, formamidine derivatives, guanidine derivatives, guanidine salts and mixtures thereof, 0 to 5 abrasive, 0 to 15 total particles selected from the group consisting of polymeric particles and polymer-coated coated particles and balance water. The solution has a tantalum nitride to TEOS selectivity of at least 3 to 1 measured with a microporous polyurethane polishing pad pressure measure normal to wafer less than 20.7 KPa.

EP3153558 describes chemical mechanical polishing (CMP) compositions, methods and systems are for polishing patterned semiconductor wafers. CMP compositions comprising an abrasive and a water soluble aluminum compound additive with a pH >7 suppress CMP stop layer (a silicon containing layer, such as silicon nitride, silicon oxide, or silicon carbide) removal rate. CMP compositions optionally contain surfactant to help wet surface; a corrosion inhibitor to provide corrosion inhibition on metal lines, vias, or trenches; and a pH adjusting agent that is used to adjust pH of the CMP polishing composition.

US2005/211953 describes aqueous polishing slurries for chemical-mechanical polishing are effective for polishing copper at high polish rates. The aqueous slurries include soluble salts of molybdenum dissolved in an oxidizing agent and molybdic acid dissolved in an oxidizing agent. Methods for polishing copper by chemical-mechanical planarization are disclosed which involve polishing copper with low pressures using a polishing pad and aqueous slurries including soluble salts of molybdenum dissolved in an oxidizing agent and molybdic acid dissolved in an oxidizing agent, particles of MoO₃ dissolved in an oxidizing agent, and particles of MoO₂ dissolved in an oxidizing agent.

EP1936674 discloses a composition and associated method for the chemical mechanical planarization (CMP) of metal substrates on semiconductor wafers. The composition contains a nonionic fluorocarbon surfactant and a per-type oxidizer (e.g., hydrogen peroxide). The composition and associated method are effective in controlling removal rates of low-k films during copper CMP and provide for tune-ability in removal rates of low-k films in relation to removal rates of copper, tantalum, and oxide films.

WO2006/133249 describes Chemical mechanical polishing (CMP) compositions and single CMP platen process for the removal of copper and barrier layer material from a microelectronic device substrate having same thereon. The process includes the in situ transformation of a Step I slurry formulation, which is used to selectively remove and planarize copper, into a Step II slurry formulation, which is used to selectively remove barrier layer material, on a single CMP platen pad.

Chemical mechanical planarization (CMP) of the barrier layer is a critical step wafer damascene process.

Therefore, there is a need to make CMP slurries with higher removal rate.

### BRIEF SUMMARY OF THE INVENTION

The present invention provides stable CMP slurries with higher Barrier and ILD removal rates. Described and disclosed herein are barrier CMP compositions, systems and methods for polishing. The compositions disclosed herein provide improved, high barrier film and ILD layer removal rates.

In one embodiment, described herein is a barrier chemical mechanical planarization polishing composition comprising:
≥1.5wt.%, ≥ 2.4wt.%, ≥ 5.0 wt.%, or ≥ 10.wt.% of abrasive;
≤10wt.%, preferably ≤ 5wt.%; more preferably ≤ 1 wt.% of chemical additive;
0.001 wt.% to 1.0 wt.% corrosion inhibitor;
water soluble solvent;
wherein
the abrasive is selected from the group consisting of high purity colloidal silica, nano-sized colloidal silica, alumina, ceria, germania, silica, titania, zirconia, alumina dopes colloidal silica in lattices, and combinations thereof;
the chemical additive comprising at least one polyprotic acid or its salt selected from the group consisting of phosphonoacetic acid, its derivatives and their salts; phosphonic acid, its derivatives and their salts; phenylphosphonic acid, its derivatives and their salts;
molybdenum diacid, its derivatives and their salts; oxalic acid, its derivatives and their salts; sulfurous acid, its derivative and their salts; arsenic acid, its derivatives and their salts; nitrobenzoic acid , its derivatives and their salts; malonic acid, its derivative and their salts;; silicic acid, its derivative and their salts; carbonic acid, its derivative and their salts; and combinations thereof, at least one polyprotic acid or its salt having more than one Pka and having a Pka1 from 0 to 12, 0.5 to 10, 1 to 7, or 1 to 3;
the corrosion inhibitor is selected from the group consisting of benzotriazole, 3-amino-1, 2, 4-triazole, 3, 5-diamine-1, 2, 4-triazole, and combinations thereof
the water soluble solvent is selected from the group consisting of DI water, a polar solvent and a mixture of DI water and polar solvent; wherein the polar solvent is selected from the group consisting of alcohol, ether, ketone, or other polar reagent;
and
the polishing composition has a pH from 2 to 12, 3 to 12, 4 to 12, 6 to 11, or 7 to 11.

The composition may further comprise at least one of
second rate booster selected from the group consisting of nitrate salt and its derivatives; nitric salt and its derivatives; chloride salt and its derivatives; and combinations thereof;
surfactant selected from the group consisting of an acetylenic surfactant, an alcohol ethoxylate surfactant, and a combination thereof;
pH adjusting agent;
oxidizing agent; and
chelator.

Preferably the composition comprises ≥ 2.4 wt.% of abrasive; and/or
≤ 5 wt.% of chemical additive.

The polishing composition may have a pH of 4 to 12; and/or the chemical additive may comprise at least one polyprotic acid or its salt having more than one Pka and having Pka1 from 0.5 to 10.

The composition may further comprise at least one of:
a surfactant selected from the group consisting of an acetylenic diol surfactant, an alcohol ethoxylate surfactant, and a combination thereof; and the surfactant is present in an amount of from 0.001 wt. % to 1.0 wt.%;
a second rate booster selected from the group consisting of nitrate salt and its derivatives; nitric salt and its derivatives; chloride salt and its derivatives; acetate salt and its derivatives; and combinations thereof; and the second rate booster is used in an amount ranging from 0.05 wt. % to 5 wt.%;
a pH adjusting agent selected from the group consisting of a) nitric acid, sulfuric acid, tartaric acid, succinic acid, citric acid, malic acid, malonic acid, various fatty acids, various polycarboxylic acids and combinations thereof to lower pH of the polishing composition; and (b) potassium hydroxide, sodium hydroxide, ammonia, tetraethylammonium hydroxide, ethylenediamine, piperazine, polyethyleneimine, modified polyethyleneimine, and combinations thereof to raise pH of the polishing composition; and the pH adjusting agent is used in an amount ranging from 0.001 wt.% to 1 wt.%;
an oxidizing agent selected from the group consisting of hydrogen peroxide, periodic acid, potassium iodate, potassium permanganate, ammonium persulfate, ammonium molybdate, ferric nitrate, nitric acid, potassium nitrate, ammonia, amine compounds, and combinations thereof; and the oxidizing agent is used in an amount ranging from about 0.05 wt.% to about 5.0 wt.%; and
a chelator selected from the group consisting of organic acids and their salts; polymeric acids and their salts; water-soluble copolymers and their salts; copolymers and their salts containing at least two different types of acid groups selected from carboxylic acid groups; sulfonic acid groups; phosphoric acids; and pyridine acids in the same molecule of a copolymer; polyvinyl acids and their salts; polyethylene oxide; polypropylene oxide; pyridine, pyridine derivatives, bipyridine, bipyridine derivatives, and combinations thereof; and the chelator is used in an amount ranging from 0.05wt.% to about 5 wt.%.

Preferably the barrier chemical mechanical planarization polishing composition comprises silicon abrasive particles having a mean particle size of 15 nm to 200 nm; 0.025 wt.% to 4 wt.% of chemical additive selected from the group consisting of malonic acid, potassium sulfite, potassium molybdate, potassium silicate, potassium oxalate monohydrate, phosphonoacetic acid, and combinations thereof; an acetylenic diol surfactant or an alcohol ethoxylate surfactant; and water; wherein the composition has a pH of 6 to 11.

Preferably the barrier chemical mechanical planarization polishing composition comprises silicon abrasive particles having a mean particle size of 25 nm and 90 nm; 0.025 wt.% to 4 wt.% of chemical additive selected from the group consisting of malonic acid, potassium sulfite, potassium molybdate, potassium silicate, potassium oxalate monohydrate, phosphonoacetic acid, and combinations thereof; second rate booster selected from the group consisting of sodium silicate, ammonium silicate, tetramethylammonium silicate, tetrabutylammonium silicate, tetraethylammonium silicate, and combinations thereof; an acetylenic diol surfactant or an alcohol ethoxylate surfactant; and water; wherein the composition has a pH of 7 to 11.

Preferably the barrier chemical mechanical planarization polishing composition comprises silicon abrasive particles having a mean particle size of 25 nm and 90 nm; 0.025 wt.% to 4 wt.% of chemical additive having at least two selected from the group consisting of malonic acid, potassium sulfite, potassium molybdate, potassium silicate, potassium oxalate monohydrate, phosphonoacetic acid, and combinations thereof; second rate booster selected from the group consisting of sodium silicate, ammonium silicate, tetramethylammonium silicate, tetrabutylammonium silicate, tetraethylammonium silicate, and combinations thereof; an acetylenic diol surfactant or an alcohol ethoxylate surfactant; and water; wherein the composition has a pH of 7 to 11.

In another aspect, the present invention provides a polishing method for chemical mechanical planarization of a semiconductor device comprising at least one surface having at least a barrier layer and a dielectric layer; the method comprising the steps of:
providing the semiconductor device;
providing a polishing pad;
providing a polishing composition of the invention;
contacting the surface of the semiconductor substrate with the polishing pad and the chemical mechanical polishing composition; and
polishing the least one surface;
wherein the barrier layer comprises tantalum or titanium containing films selected from the group consisting of tantalum, tantalum nitride, tantalum tungsten silicon carbide, titanium, titanium nitride, titanium-tungsten, titanium tungsten nitride, and combinations thereof; and the dielectric layer selected from the group consisting of oxide film, low-K material, and combinations thereof.

Preferably the at least one surface comprises tantalum and tantalum nitride, and silicon dioxide.

In yet another aspect, the present invention provides a system for chemical mechanical planarization, comprising:
a semiconductor device comprising at least one surface having at least a barrier layer and a dielectric layer;
a polishing pad; and
a polishing composition of the invention;
wherein the barrier layer comprises tantalum or titanium containing films selected from the group consisting of tantalum, tantalum nitride, tantalum tungsten silicon carbide, titanium, titanium nitride, titanium-tungsten, titanium tungsten nitride, and combinations thereof; and the dielectric layer selected from the group consisting of oxide film, silane oxide film, low-K material, and combinations thereof; and
the at least one surface is in contact with the polishing pad and the polishing composition.

Preferably the at least one surface comprises tantalum and tantalum nitride, and silicon dioxide.

A polyprotic acid is an acid that can donate more than one proton or hydrogen atom per molecule to an aqueous solution during dissociation. A diprotic acid is an acid that can donate two proton or hydrogen atoms, and a triprotic acid is an acid that can donate three proton or hydrogen atoms. A diprotic acid and a triprotic acid are polyprotic acids.

The chemical additive comprises at least one polyprotic acid or its salt that has more than one Pka and having Pka1 from 0 to 12, preferably from 0.5 to 10, 1 to 7, or 1 to 3. Pka1 is the negative logs of the acidity constant for the first stage in which a polyprotic acid loses a proton or hydrogen atom. The Pka is as measured at 20°C.

The chemical additive comprises at least one polyprotic acid or its salt selected from the group consisting of phosphonoacetic acid, its derivatives and their salts; phosphonic acid, its derivatives and their salts; phenylphosphonic acid, its derivatives and their salts; molybdenum diacid, its derivatives and their salts; oxalic acid, its derivatives and their salts; sulfurous acid, its derivative and their salts; arsenic acid, its derivatives and their salts; nitrobenzoic acid , its derivative and their salts; malonic acid, its derivative and their salts; tartaric acid, its derivative and their salts; phthalic acid , its derivative and their salts; silicic acid, its derivative and their salts; carbonic acid, its derivative and their salts; and combinations thereof.

The chemical additive is used in an amount ≤ 10 wt.% , preferably ranging from about 0.001 wt.% to about 10 wt.%; from about 0.01 wt.% to about 5 wt.%; from about 0.025 wt.% to about 4 wt.%, from about 0.025 wt.% to about 3 wt.%, or from about 0.05 wt.% to about 1 wt.%. As used herein, and unless otherwise indicated, all references to the wt.% of a component of a composition indicate the weight percent of that component by total weight of the composition.

The water-soluble solvent is selected from DI water, a polar solvent and a mixture of DI water and polar solvent. The polar solvent can be any alcohol, ether, ketone, or other polar reagent. Examples of polar solvents include alcohols, such as isopropyl alcohol, ethers, such as tetrahydrofuran and diethyl ether, and ketones, such as acetone.

The corrosion inhibitor is selected from benzotriazole or benzotriazole derivatives, 3-amino-1, 2, 4-triazole, 3, 5-diamine-1, 2, 4-triazole, and combinations thereof. The corrosion inhibitor is present in an amount ranging from 0.001 wt.% to 1.0 wt.%; preferably 0.0025 wt.% to 0.75 wt.%; 0.005 wt.% to 0.5 wt.%; 0.0075 wt.% to 0.25 wt.%; or 0.01 wt.% to 0.1 wt.%.

Examples of the surfactant includes but is not limited to a). non-ionic surface wetting agents; b). anionic surface wetting agents; c). cationic surface wetting agents; d). ampholytic surface wetting agents; and combinations thereof. The surfactant is present in an amount ranging from about 0.0 wt.% to about 10 wt.%; 0.0005 wt.% to about 5 wt.%; 0.001 wt.% to about 1.0 wt.%; or 0.005 to 0.25 wt. %.

More specifically, examples of surfactants include, but are not limited to, dodecyl sulfate sodium salt, sodium lauryl sulfate, dodecyl sulfate ammonium salt, secondary alkane sulfonates, alcohol ethoxylate, acetylenic surfactant, and any combination thereof.

Examples of the pH adjusting agent includes but is not limited to (a) nitric acid, sulfuric acid, tartaric acid, succinic acid, citric acid, malic acid, malonic acid, various fatty acids, various polycarboxylic acids and combinations thereof to lower pH of the polishing composition; and (b) potassium hydroxide, sodium hydroxide, ammonia, tetraethylammonium hydroxide, ethylenediamine, piperazine, polyethyleneimine, modified polyethyleneimine, and combinations thereof to raise pH of the polishing composition. The pH adjusting agent is present in an amount ranging from about 0 wt.% to 3 wt.%; preferably 0.001 wt.% to 1 wt.%; more preferably 0.01 wt.% to 0.5 wt.% pH adjusting agent.

The polishing composition has a pH from 2 to 12, 3 to 12, 4 to 12, 6 to 11, or 7 to 11.

Example of the second rate booster agent includes but is not limited to an organic acid or its salt; inorganic salt. The molar conductivities in aqueous solutions at 25°C of the second rate booster agent is preferably ≥75 S•cm²/mol. The second rate booster agent is present in an amount ranging from about 0.0 wt.% to about 10 wt.%; about 0.001 wt.% to about 7 wt.%; about 0.05 wt. % to about 5 wt.%; preferably from about 0.01 wt.% to about 3 wt.%.

Example of the second rate booster agent includes but is not limited to nitrate salt (potassium, sodium, ammonium, lithium, piperidinium, their derivatives), nitric salt (potassium, sodium, ammonium, lithium, piperidinium, their derivatives), chloride salt (potassium, sodium, ammonium, lithium, piperidinium, their derivatives), acetate salt (potassium, sodium, ammonium, lithium, piperidinium, their derivatives), and combinations thereof

Example of the oxidizing agent includes but is not limited to hydrogen peroxide, periodic acid, potassium iodate, potassium permanganate, ammonium persulfate, ammonium molybdate, ferric nitrate, nitric acid, potassium nitrate, ammonia, amine compounds, and combinations thereof. The oxidizing agent is present in an amount ranging from about 0.0 wt.% to about 10 wt.%; 0.01 wt. % to 7 wt.%; 0.05 wt. % to 5 wt.%; or from about 0.1 wt.% to about 2 wt.%.

Suitable chelator includes but is not limited to organic acids and their salts; polymeric acids and their salts; water-soluble copolymers and their salts; copolymers and their salts containing at least two different types of acid groups selected from carboxylic acid groups; sulfonic acid groups; phosphoric acids; and pyridine acids in the same molecule of a copolymer; polyvinyl acids and their salts; polyethylene oxide; polypropylene oxide; pyridine, pyridine derivatives, bipyridine, bipyridine derivatives, and combinations thereof.

Example of the chelator includes but is not limited to potassium citrate, benzosulfonic acid, 4-tolyl sulfonic acid, 2,4-diamino-benzosulfonic acid, and malonic acid, itaconic acid, malic acid, tartaric acid, citric acid, oxalic acid, gluconic acid, lactic acid, mandelic acid, amino acids, polycarboxy amino acids, phosphonic acids, salts thereof, and combinations thereof.

The chelator is used in an amount ranging from about 0.0 wt.% to about 10 wt.%; from about 0.01 wt.% to about 10 wt.%; from about 0.05 wt.% to about 5 wt.%; or preferably 0.01 wt. % to 1.0 wt.%.

### BRIEF DESCRIPTION OF SEVERAL VIEWS OF THE DRAWINGS

Figure 1 Removal Rate comparison between Slurry A (containing no chemical additive) and Slurry B(containing the chemical additive)
Figure 2 Removal Rate comparison between Slurry C (containing no chemical additive) and Slurry D (containing the chemical additive)
Figure 3 Removal Rate comparison between Slurry E (containing no chemical additive) and Slurry F (containing the chemical additive)
Figure 4 Removal Rate comparison between slurry G POU (point of use) (containing no chemical additive) and Slurry H POU(containing the chemical additive)
Figure 5 Removal Rate comparison between slurry I POU (containing no chemical additive) and Slurry J POU (containing the chemical additive)
Figure 6 Removal Rate comparison between Slurry E (containing no chemical additive) and Slurry K (containing the chemical additive)
Figure 7 Removal Rate comparison between slurry I POU (containing no chemical additive) and Slurry L POU (containing the chemical additive)

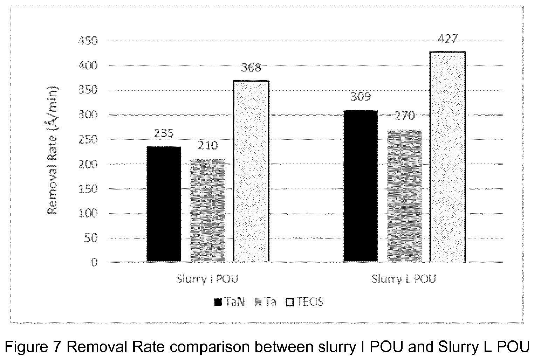

Figure 7 Removal Rate comparison between slurry M POU (containing no chemical additive) and Slurry N POU (containing the chemical additive)

### DETAILED DESCRIPTION OF THE INVENTION

Described herein are stable CMP slurries polishing a semiconductor substrate or device having a conductive metal layer, an underlying barrier film, and a dielectric layer having imbedded metal interconnect structures.

The present invention provides stable CMP slurries with higher Barrier and ILD removal rates. Described and disclosed herein are barrier CMP compositions, systems and methods for polishing. The compositions disclosed herein boost the barrier film ad ILD removal rates.

The conductive metal layer comprises such as Cu, CuMn, Co, CoMo, Al, AICo, Ru, RuTa, RuTiN, Mn, and combinations thereof. The barrier or liner layer comprises tantalum or titanium containing films selected from the group consisting of Ta, TaN, Ti, TiN, TiW or TiWN, and combinations thereof. The underlying interlayer dielectric (ILD) layer comprises silicon dioxide film such as SiO2, TEOS; low-K dielectric material; and combinations thereof.

The barrier chemical mechanical planarization polishing composition comprises:
≥1.5wt.%, ≥ 2.4wt.%, ≥ 5.0 wt.%, ≥ 10.wt.% of abrasive;
≤10wt.%, preferably ≤ 5wt.%; more preferably ≤ 1 wt.% of chemical additive;
corrosion inhibitor,
water soluble solvent;
optionally any one of
second rate booster
surfactant;
pH adjusting agent;
oxidizing agent; and
chelator; wherein
the abrasive is selected from the group consisting of high purity colloidal silica, nano-sized colloidal silica, alumina, ceria, germania, silica, titania, zirconia, alumina dopes colloidal silica in lattices, and combinations thereof;
the chemical additive comprising at least one polyprotic acid or its salt selected from the group consisting of phosphonoacetic acid, its derivatives and their salts; phosphonic acid, its derivatives and their salts; phenylphosphonic acid, its derivatives and their salts;
molybdenum diacid, its derivatives and their salts; oxalic acid, its derivatives and their salts; sulfurous acid, its derivative and their salts; arsenic acid, its derivatives and their salts; nitrobenzoic acid , its derivatives and their salts; malonic acid, its derivative and their salts; silicic acid, its derivative and their salts; carbonic acid, its derivative and their salts; and combinations thereof, at least one polyprotic acid or its salt having more than one Pka and having a Pka1 from 0 to 12, 0.5 to 10, 1 to 7, or 1 to 3;
the corrosion inhibitor is selected from the group consisting of benzotriazole, 3-amino-1, 2, 4-triazole, 3, 5-diamine-1, 2, 4-triazole, and combinations thereof the water soluble solvent is selected from the group consisting of DI water, a polar solvent and a mixture of DI water and polar solvent; wherein the polar solvent is selected from the group consisting of alcohol, ether, ketone, or other polar reagent;
the second rate booster has its molecular molar conductivity ≥75 S•cm²/mol in aqueous solution at 25°C; and
the polishing composition has a pH of 2 to 12, 3 to 12, 4 to 12, 6 to 11, or 7 to 11.

The polishing compositions of the present invention comprise an abrasive as defined in the claims. Suitable abrasives for polishing compositions are nano-sized particles include, but are not limited to, nano-sized colloidal silica or high purity colloidal silica particles; nano-sized inorganic metal oxide particles, such as alumina, titania, zirconia, ceria, and combinations thereof; nano-sized diamond particles; nano-sized silicon nitride particles; mono-modal, bi-modal, or multi-modal colloidal abrasive particles; organic polymer-based soft abrasives; surface-coated or modified abrasives; and combinations thereof.

The surface-coated or modified abrasives include but are not limited to the colloidal silica particles doped by other metal oxide within lattice of the colloidal silica, such as alumina doped silica particles, colloidal aluminum oxide, which include alpha-, beta-, and gamma-types of aluminum oxides, colloidal and photoactive titanium dioxide, cerium oxide, colloidal cerium oxide, nano-sized diamond particles, nano-sized silicon nitride particles, mono-modal, bi-modal, multi-modal colloidal abrasive particles, zirconium oxide, organic polymer-based soft abrasives, surface-coated or modified abrasives, and mixtures thereof.

The nano-sized particles have narrow or broad particle size distributions, various sizes and various shapes. The various shapes of the abrasives include spherical shape, cocoon shape, aggregate shape and other shapes.

The abrasive particles may be purified using a suitable method such as ion exchange to remove metal impurities that may help improve the colloidal stability. Alternatively, high purity silica abrasive particles that are manufactured from precursors other than metal silicates can be used.

Preferred abrasives include, but are not limited to, high purity colloidal silica, alumina, ceria, germania, silica, titania, zirconia, alumina dopes colloidal silica in lattices, and mixtures thereof. Colloidal silica is a most preferred abrasive particle.

The silica can be any of precipitated silica, fumed silica, silica fumed, pyrogenic silica, silica doped with one or more adjutants, or any other silica-based compound. In an alternate embodiment, the silica can be produced, for example, by a process selected from the group consisting of a sol-gel process, a hydrothermal process, a plasma process, a fuming process, a precipitation process, and any combination thereof.

It is preferred that the mean particle size of the abrasive as measured by Disc Centrifuge (DC) particle sizing method is between 10 nm and 300 nm, or more preferably between 15 nm and 200 nm, and even more preferably between 25 nm and 90 nm.

In general, the above-mentioned abrasive particles may be used either alone or in combination with one another. Two or more abrasive particles with different sizes may also be combined to obtain excellent performance.

The abrasive is present in the compositions of the present invention in an amount ranging from ≥1.5wt.%, preferably≥ 2.4wt.%, ≥ 5.0 wt.%, ≥ 10.wt.% relative to the total weight of the CMP composition.

The water-soluble solvent includes DI water, a polar solvent or a mixture of DI water and polar solvent. The polar solvent can be any alcohol, ether, ketone, or other polar reagent. Examples of polar solvents include alcohols, such as isopropyl alcohol, ethers, such as tetrahydrofuran and diethyl ether, and ketones, such as acetone.

The chemical additive has PKa1 from 0 to 12, preferably 0.5 to 10, 1 to 7, or 1 to 3.

The chemical additives are used as the first rate booster.

More specifically, the chemical additive comprises at least one polyprotic acid or its salt selected from the group consisting of phosphonoacetic acid, its derivatives and their salts; phosphonic acid, its derivatives and their salts; phenylphosphonic acid, its derivatives and their salts; molybdenum diacid, its derivatives and their salts; oxalic acid, its derivatives and their salts; sulfurous acid, its derivative and their salts; arsenic acid, its derivatives and their salts; nitrobenzoic acid , its derivative and their salts; malonic acid, its derivative and their salts; tartaric acid, its derivative and their salts; phthalic acid, its derivative and their salts; silicic acid, its derivative and their salts; carbonic acid, its derivative and their salts; and combinations thereof. Examples include potassium sulfite, malonic acid, potassium silicate, potassium molybdate, phosphonoacetic acid, potassium oxalate monohydrate, phenylphosphonic acid, L-tartaric acid and potassium carbonate.

The chemical additive is used in an amount ranging from about 0.001 wt.% to about 10 wt.%; preferably from about 0.01 wt.% to about 5 wt.%;_from about 0.025 wt.% to about 4 wt.%, or from about 0.05 wt.% to about 1 wt. %.

A surfactant is used in the barrier CMP slurry as surface wetting agent; suitable surfactant compounds that may be added to the barrier CMP slurry as surface wetting agent include, any of the numerous nonionic, anionic, cationic or amphoteric surfactants known to those skilled in the arts. One example of the nonionic surfactant is tricosaethylene glycol dodecyl ether.

Examples of surfactants also include, but are not limited to, dodecyl sulfate sodium salt, sodium lauryl sulfate, dodecyl sulfate ammonium salt, secondary alkane sulfonates, alcohol ethoxylate, acetylenic surfactant, and any combination thereof.

Examples of suitable commercially available surfactants include TRITON ^{™}, Tergitol^{™}, DOWFAX^{™} family of surfactants manufactured by Dow Chemicals and various surfactants in SURFYNOL^{™}, DYNOL^{™}, Zetasperse^{™}, Nonidet^{™}, and Tomadol^{™} surfactant families, manufactured by Air Products and Chemicals.

Suitable surfactants of surfactants may also include polymers comprising ethylene oxide (EO) and propylene oxide (PO) groups. An example of EO-PO polymer is Tetronic^{™} 90R4 from BASF Chemicals.

When employed, the amount of surfactant typically ranges from 0.0001 wt. % to about 1.0 wt. % relative to the total weight of the barrier CMP composition. When employed, the range is 0.0 wt.% to about 10 wt.%; 0.0005 wt.% to about 5 wt.%; 0.001 wt.% to about 1wt.%; or 0.005 to 0.25 wt. %.

The corrosion inhibitor is selected from the group consisting of benzotriazole or benzotriazole derivatives, 3-amino-1, 2, 4-triazole, 3, 5-diamine-1, 2, 4-triazole, and combinations thereof.

The corrosion inhibitor is used in an amount ranging from 0.001 wt.% to 1.0 wt.%; preferably 0.0025 wt.% to 0.75 wt.%; 0.005 wt.% to 0.5 wt.%; 0.0075 wt.% to 0.25 wt.%; or 0.01 wt.% to 0.1 wt.%.

Example of the pH adjusting agent includes but is not limited to (a) nitric acid, sulfuric acid, tartaric acid, succinic acid, citric acid, malic acid, malonic acid, various fatty acids, various polycarboxylic acids and combinations thereof to lower pH of the polishing composition; and (b) potassium hydroxide, sodium hydroxide, ammonia, tetraethylammonium hydroxide, ethylenediamine, piperazine, polyethyleneimine, modified polyethyleneimine, and combinations thereof to raise pH of the polishing composition. The pH adjusting agent is used in an amount ranging from about 0.0001 wt.% to about 3 wt.%;. The polishing composition has a pH from about 2 to 12, 3 to 12, 4 to 12, 6 to 11, or 7 to 11.

Example of the second rate booster agent includes but is not limited to an organic acid or its salt; and inorganic salt. Preferably the molar conductivities in aqueous solutions at 25°C of the second rate booster agent is ≥75 S•cm²/mol. The second rate booster agent is present in an amount ranging from about 0.0 wt.% to about 10 wt.%; about 0.001 wt.% to about 7 wt.%; about 0.005 wt.% to about 5 wt.%, or from about 0.01 wt.% to about 3 wt.%.

Example of the second rate booster agent includes but is not limited to nitrate salt (potassium, sodium, ammonium, lithium, piperidinium, their derivatives), nitric salt (potassium, sodium, ammonium, lithium, piperidinium, their derivatives), chloride salt (potassium, sodium, ammonium, lithium, piperidinium, their derivatives), acetate salt (potassium, sodium, ammonium, lithium, piperidinium, their derivatives), and combinationsthereof. Preferred examples include potassium acetate and potassium nitrate.

Example of the oxidizing agent includes but is not limited to hydrogen peroxide, periodic acid, potassium iodate, potassium permanganate, ammonium persulfate, ammonium molybdate, ferric nitrate, nitric acid, potassium nitrate, ammonia, amine compounds, and combinations thereof.

The oxidizing agent is used in an amount ranging from about 0.0 wt.% to about 10 wt.%; 0.01 wt. % to 7 wt.%; 0.05 wt. % to 5 wt.%;_or from about 0. 1 wt.% to about 2 wt.%.

Suitable chelator includes but is not limited to organic acids and their salts; polymeric acids and their salts; water-soluble copolymers and their salts; copolymers and their salts containing at least two different types of acid groups selected from carboxylic acid groups; sulfonic acid groups; phosphoric acids; and pyridine acids in the same molecule of a copolymer; polyvinyl acids and their salts; polyethylene oxide; polypropylene oxide; pyridine, pyridine derivatives, bipyridine, bipyridine derivatives, and combinations thereof.

Example of the chelator is selected from the group consisting of potassium citrate, benzosulfonic acid, 4-tolyl sulfonic acid, 2,4-diamino-benzosulfonic acid, and malonic acid, itaconic acid, malic acid, tartaric acid, citric acid, oxalic acid, gluconic acid, lactic acid, mandelic acid, amino acids, polycarboxy amino acids, phosphonic acids and combinations thereof and salts thereof.

The chelator is used in an amount ranging from about 0.0 wt.% to about 10 wt.%; preferably from about 0.05wt.% to about 5 wt.%; and more preferably 0.01 wt. % to 1.0 wt.%.

The present invention also provides a polishing method for chemical mechanical planarization of a semiconductor device comprising at least one surface having at least a barrier layer and a dielectric layer; the method comprising the steps of:
providing the semiconductor device;
providing a polishing pad;
providing a polishing composition of the invention;
contacting the surface of the semiconductor substrate with the polishing pad and the chemical mechanical polishing composition; and
polishing the least one surface;
wherein the barrier layer comprises tantalum or titanium containing films selected from the group consisting of tantalum, tantalum nitride, tantalum tungsten silicon carbide, titanium, titanium nitride, titanium-tungsten, titanium tungsten nitride, and combinations thereof; and the dielectric layer selected from the group consisting of silicon dioxide film, low-K material, and combinations thereof.

Preferably the at least one surface comprises tantalum and tantalum nitride, and silicon dioxide.

The present invention further provides a system for chemical mechanical planarization, comprising:
a semiconductor device comprising at least one surface having at least a barrier layer and a dielectric layer;
a polishing pad; and
a polishing composition as described herein;
wherein the barrier layer comprises tantalum or titanium containing films selected from the group consisting of tantalum, tantalum nitride, tantalum tungsten silicon carbide, titanium, titanium nitride, titanium-tungsten, titanium tungsten nitride, and combinations thereof; and the dielectric layer selected from the group consisting of silicon dioxide film, low-K material, and combinations thereof; and
the at least one surface is in contact with the polishing pad and the polishing composition.

Preferably the at least one surface comprises tantalum and tantalum nitride, and silicon dioxide.

### General Experimental Procedure

In the examples presented below, all percentages are weight percentages unless otherwise indicated. Water is added to make the composition 100 wt.%.

In the examples presented below, CMP experiments were run using the procedures and experimental conditions given below.

The CMP tool that was used in the examples is a Mirra^{®}, manufactured by Applied Materials, 3050 Boweres Avenue, Santa Clara, California, 95054. Polishing was performed on VP3500 polisher pad from Dow Chemicals. Polishing was performed at 1.1 psi down force and 93 RPM table speed with 200 ml/min composition flow rates. Polishing experiments were conducted using electroplating deposited copper, plasma enhanced deposition of tetraethoxy silane (TEOS) dielectric, Tantalum (Ta) and Tantalum Nitride (TaN) films. These blanket wafers were purchased from Silicon Valley Microelectronics, 1150 Campbell Ave, CA, 95126, and Advantiv Corporation. Defects on the wafer films were measured using Surfscan SP2 wafer inspection tool, manufactured by KLA-Tencor, One Technology Drive, Milpitas, CA95035.

Silicon particle about 60 nm (measured by light scattering) purchased from Fuso Chemical Co. LTD, Japan.

### Example 1:

The chemical constituents used for the slurry were shown in Table 1. DI Water was added to make the composition 100 wt. %.

The pH of the slurry 7.5-9.

**Table 1**

| Composition | | Slurry A | Slurry B |
|---|---|---|---|
| DI water | Solvent | 94.67 | 94.57 |
| Malonic acid | Chemical additive | | 0.1 |
| Potassium nitrate | Second rate booster | 0.2 | 0.2 |
| Potassium hydroxide | pH adjusting agent | 0.1 | 0.1 |
| Silica Particle | Abrasive | 5 | 5 |
| benzotriazole | Inhibitor | 0.02 | 0.02 |
| Surfactant (surfynol 465) | Surfactant | 0.01 | 0.01 |

The slurries were prepared by adding each chemical constituent shown in Table I continuously at room temperature with a short break (several minutes) apart from each component.

The slurries were used for polishing after 1 wt. % hydrogen peroxide was added to the slurries as an oxidizing agent.

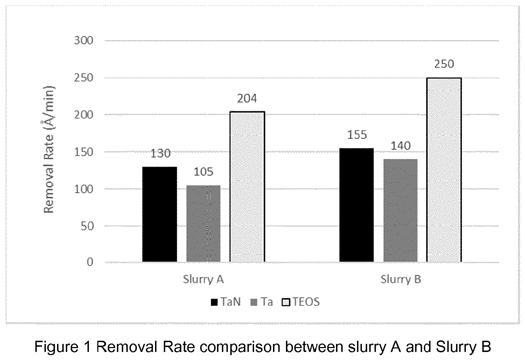

Polishing results for TaN, Ta and TEOS were shown in Figure 1.

As shown in Figure 1, both barrier (Ta and TaN) and ILD (TEOS) removal rates were boosted with the addition of malonic acid.

Malonic acid is a polyprotic acid (diprotic) with PKa1 of 2.8 at 20°C.

Potassium nitrate is a second rate booster in which K⁺ has molar ionic conductivity in aqueous solution at 25°C of 73.5 S•cm²/mol and NO3⁻ has molar ionic conductivity in aqueous solution at 25°C of 71.46 S•cm²/mol.

Thus, Example 1 demonstrated that the addition of a polyprotic acid with PKa1 between 1 and 3 can boost both barrier and ILD removal rates

### Example 2:

The chemical constituents used for the slurry were shown in Table 1. DI Water was added to make the composition 100 wt. %.

The pH of the slurry 10-10.5.

**Table 2**

| Composition | | Slurry C | Slurry D |
|---|---|---|---|
| DI water | Solvent | 94.41 | 94.21 |
| Potassium sulfite | Chemical additive | | 0.2 |
| Potassium acetate | Second rate booster | 0.4 | 0.4 |
| Potassium hydroxide | pH adjusting agent | 0.17 | 0.17 |
| Silica Particle | Abrasive | 5 | 5 |
| benzotriazole | Inhibitor | 0.01 | 0.01 |
| Surfactant (surfynol 465) | Surfactant | 0.01 | 0.01 |

The slurries were prepared by adding each chemical constituent shown in Table I continuously at room temperature with a short break (several minutes) apart from each component.

The slurries were used for polishing after 1 wt. % hydrogen peroxide was added to the slurries as an oxidizing agent.

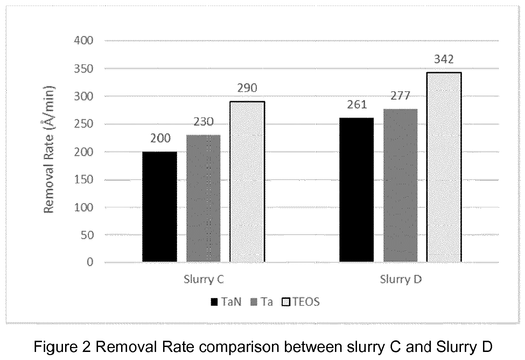

Polishing results for TaN, Ta and TEOS were shown in Figure 2.

As shown in Figure 2, both barrier (Ta and TaN) and ILD (TEOS) removal rates were boosted with the addition of potassium sulfite.

Potassium sulfite is a salt of sulfurous acid (diprotic acid) with PKa1 of 1.85 at 20°C.

Potassium acetate is a second rate booster in which K⁺ has molar ionic conductivity in aqueous solution at 25°C of 73.5 S•cm²/mol and acetate ion has molar ionic conductivity in aqueous solution at 25°C of 40.9 S•cm²/mol.

Thus, Example 2 demonstrated that the addition of a salt of polyprotic acid with PKa1between 1 and 3 can boost both barrier and ILD removal rates.

### Example 3:

The chemical constituents used for the slurry were shown in Table 3. DI Water was added to make the composition 100 wt. %.

The pH of the slurry was around 7-10.

**Table 3**

| Composition | | Slurry E | Slurry F |
|---|---|---|---|
| DI water | Solvent | 93.97 | 93.37 |
| Potassium molybdate | Chemical additive | | 0.60 |
| Potassium Silicate | Chemical additive | 0 | 1 |
| Silica Particle | Abrasive | 5 | 5 |
| benzotriazole | Inhibitor | 0.0200 | 0.0200 |
| Surfactant (Dynol 607) | Surfactant | 0.01 | 0.01 |

The slurries were prepared by adding each chemical constituent shown in Table 3 continuously at room temperature with a short break (several minutes) apart from each component.

The slurries were used for polishing after 1 wt. % hydrogen peroxide was added to the slurries as an oxidizing agent.

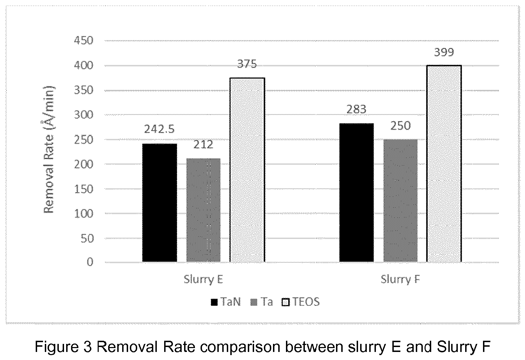

Polishing results for TaN, Ta and TEOS were shown in Figure 3.

As shown in Figure 3, both barrier (Ta and TaN) and ILD (TEOS) removal rates were boosted with the addition of both potassium molybdate and potassium silicate.

Potassium molybdate is the salt of molybdenum diacid, and molybdenum diacid is a diprotic acid with PKa1 at 20°C of 2.9.

Potassium silicate is the salt of silicic acid, and silicic acid is a polyprotic acid with PKa1 at 20°C of 6-10.

Thus, Example 3 demonstrated that the addition of both a salt of polyprotic acid with PKa1between 1 and 3 and a salt of polyprotic acid with PKa1 between 0.5 to 10 can boost both barrier and ILD removal rates.

### Example 4:

The chemical constituents used for the slurry were shown in Table 4. DI Water was added to make the composition 100 wt. %.

The PH of the slurry is 7.5-8.5.

**Table 4**

| Composition | | Slurry G | Slurry H |
|---|---|---|---|
| DI water | Solvent | 82.14 | 81.84 |
| Phosphonoacetic acid | Chemical additive | | 0.30 |
| Potassium hydroxide | pH adjusting agent | 0.17 | 0.17 |
| Potassium nitrate | Second rate booster | 0.6 | 0.6 |
| Silica Particle | Abrasive | 17 | 17 |
| benzotriazole | Inhibitor | 0.0600 | 0.0600 |
| Surfactant (Dynol 607) | Surfactant | 0.03 | 0.03 |

The slurry was prepared with a normal slurry preparation process, that is, by adding each chemical constituent shown in Table 4continuously at room temperature with a short break (several minutes) apart from each component.

The slurries at point of use (POU) for polishing after diluting slurries G and H with DI water and adding 1 wt.% hydrogen peroxide as an oxidizing agent, as shown in Table 5.

**Table 5**

| | Slurry G POU | Slurry H POU |
|---|---|---|
| DI water | 66 | 66 |
| Slurry G | 33 | |
| Slurry H | | 33 |
| hydroqen peroxide | 1 | 1 |

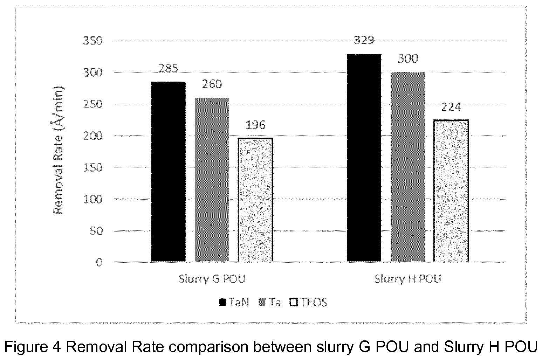

As shown in Figure 4, both barrier (Ta and TaN) and ILD (TEOS) removal rate was boosted with addition of phosphonoacetic acid as rate booster slurry component.

Phosphonoacetic acid is a triprotic acid with PKa1 at 20°C of 1.64.

Potassium nitrate is a rate booster in which K⁺ has molar ionic conductivity in aqueous solution at 25°C of 73.5 S•cm²/mol and NO3⁻ has molar ionic conductivity in aqueous solution at 25°C of 71.46 S•cm²/mol.

Thus, Example 4 demonstrated that addition of a polyprotic acid with PKa1 between 1 and 3 can booster both barrier and ILD removal rate.

### Example 5

The chemical constituents used for the slurry were shown in Table 6. DI Water was added to make the composition 100 wt. %.

The PH of the slurry is 10-11.

**Table 6**

| Composition | | Slurry I | Slurry J |
|---|---|---|---|
| DI water | Solvent | 85.02 | 81.82 |
| Potassium oxalate monohydrate | Chemical additive | | 0.50 |
| Potassium Silicate | Chemical additive | 0 | 2.7 |
| Silica Particle | Abrasive | 14.9 | 14.9 |
| benzotriazole | Inhibitor | 0.0500 | 0.0500 |
| Surfactant (Dynol 607) | Surfactant | 0.03 | 0.03 |

The slurry was prepared with a normal slurry preparation process, that is, by adding each chemical constituent shown in Table 6 continuously at room temperature with a short break (several minutes) apart from each component.

The slurries at point of use (POU) for polishing were slurries G and H after diluting with DI water and adding 1 wt.% hydrogen peroxide as an oxidizing agent, as shown in Table 7.

**Table 7**

| | Slurry I POU | Slurry J POU |
|---|---|---|
| DI water | 66 | 66 |
| Slurry I | 33 | |
| Slurry J | | 33 |
| hydroqen peroxide | 1 | 1 |

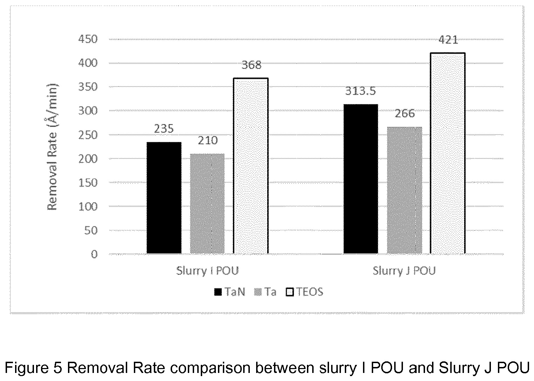

As shown in Figure 5, both barrier (Ta and TaN) and ILD (TEOS) removal rates were boosted with the addition of both potassium oxalate and potassium silicate.

Potassium oxalate monohydrate is a salt of diprotic acid with PKa1 at 20°C of 1.23.

Potassium silicate is the salt of silicic acid, and silicic acid is a polyprotic acid with PKa1 at 20°C of 6-10.

Thus, Example 5 demonstrated that the addition of both a salt of polyprotic acid with PKa1between 1 and 3 and a salt of polyprotic acid with PKa1 between 0.5 to 10 can boost both barrier and ILD removal rates.

### Example 6:

The chemical constituents used for the slurry were shown in Table 8. DI Water was added to make the composition 100 wt. %.

The PH of the slurry is 9-11.

**Table 8**

| Composition | | Slurry E | Slurry K |
|---|---|---|---|
| DI water | Solvent | 94.97 | 93.87 |
| Phosphonacetic acid | Chemical additive | | 0.10 |
| Potassium Silicate | Chemical additive | 0 | 1 |
| Silica Particle | Abrasive | 5 | 5 |
| benzotriazole | Inhibitor | 0.0200 | 0.0200 |
| Surfactant (Dynol 607) | Surfactant | 0.01 | 0.01 |

The slurry was prepared with a normal slurry preparation process, that is, by adding each chemical constituent shown in Table 8 continuously at room temperature with a short break (several minutes) apart from each component.

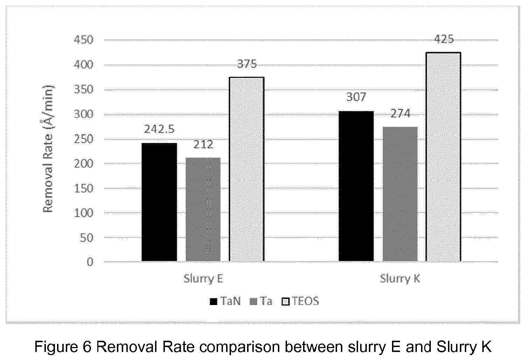

As shown in Figure 6, both barrier (Ta and TaN) and ILD (TEOS) removal rates were boosted with the addition of both phosphonacetic and potassium silicate.

Phosphonacetic acid is a diprotic acid with PKa1 at 20°C of 1.64.

Potassium silicate is the salt of silicic acid, and silicic acid is a polyprotic acid with PKa1 at 20°C of 6-10.

Thus, Example 6 demonstrated that the addition of both a salt of polyprotic acid with PKa1between 1 and 3 and a salt of polyprotic acid with PKa1 between 0.5 to 10 can boost both barrier and ILD removal rates.

### Example 7:

The chemical constituents used for the slurry were shown in Table 9. DI Water was added to make the composition 100 wt. %.

The PH of the slurry is 7-11.

**Table 9**

| Composition | | Slurry I | Slurry L |
|---|---|---|---|
| DI water | Solvent | 85.02 | 81.92 |
| Phenylphosphonic acid | Chemical additive | | 0.40 |
| Potassium Silicate | Chemical additive | 0 | 2.7 |
| Silica Particle | Abrasive | 14.9 | 14.9 |
| benzotriazole | Inhibitor | 0.0500 | 0.0500 |
| Surfactant (Dynol 607) | Surfactant | 0.03 | 0.03 |

The slurry was prepared with a normal slurry preparation process, that is, by adding each chemical constituent shown in Table 9 continuously at room temperature with a short break (several minutes) apart from each component.

The slurries at point of use (POU) for polishing were slurries G and H after diluting with DI water and adding 1 wt.% hydrogen peroxide as an oxidizing agent, as shown in Table 7.

**Table 10**

| | Slurry I POU | Slurry L POU |
|---|---|---|
| DI water | 66 | 66 |
| Slurry I | 33 | |
| Slurry L | | 33 |
| hydroqen peroxide | 1 | 1 |

As shown in Figure 7. both barrier (Ta and TaN) and ILD (TEOS) removal rates were boosted with the addition of both phenylphosphonic acid and potassium silicate.

Phenylphosphonic acid is a diprotic acid with PKa1 at 20°C of 1.63.

Potassium silicate is the salt of silicic acid, and silicic acid is a polyprotic acid with PKa1 at 20°C of 6-10.

Thus, Example 7 demonstrated that the addition of both a salt of polyprotic acid with PKa1between 1 and 3 and a salt of polyprotic acid with PKa1 between 0.5 to 10 can boost both barrier and ILD removal rates.

### Example 8:

The chemical constituents used for the slurry were shown in Table 11. DI Water was added to make the composition 100 wt. %.

The PH of the slurry is 7-11.

**Table 11**

| Composition | | Slurry M | Slurry N |
|---|---|---|---|
| DI water | Solvent | 84.82 | 83.02 |
| L-tartaric acid | Chemical additive | | 0.3 |
| Potassium hydroxide | PH adjusting agent | 0.2 | 0.2 |
| Potassium carbonate | Chemical additive | | 1.5 |
| Silica Particle | Abrasive | 14.9 | 14.9 |
| benzotriazole | Inhibitor | 0.05 | 0.05 |
| Surfactant (Dynol 607) | Surfactant | 0.03 | 0.03 |

The slurry was prepared with a normal slurry preparation process, that is, by adding each chemical constituent shown in Table 11 continuously at room temperature with a short break (several minutes) apart from each component.

The slurries at point of use (POU) for polishing were slurries G and H after diluting with DI water and adding 1 wt.% hydrogen peroxide as an oxidizing agent, as shown in Table 7.

**Table 12**

| | Slurry M POU | Slurry N POU |
|---|---|---|
| DI water | 66 | 66 |
| Slurry M | 33 | |
| Slurry N | | 33 |
| hydroqen peroxide | 1 | 1 |

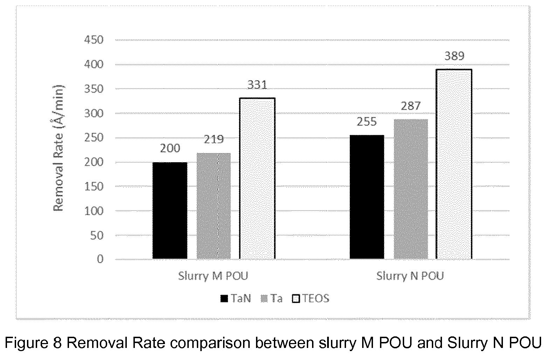

As shown in Figure 8. both barrier (Ta and TaN) and ILD (TEOS) removal rates were boosted with the addition of both L-tartaric acid and potassium carbonate.

L-tartaric acid is a polyprotic acid with PKa1 at 20°C of 2.82.

Potassium carbonate is a salt of diprotic acid with PKa1 at 20°C of 6.3.

Thus, Example 8 demonstrated that the addition of both a salt of polyprotic acid with PKa1between 1 and 3 and a salt of polyprotic acid with PKa1 between 1 to 7 can boost both barrier and ILD removal rates.

Working examples have demonstrated that the barrier layer slurry using chemical additive comprising diprotic acid, its derivatives and their salts; triprotic acid, its derivatives and their salts; and combinations thereof boosts barrier and ILD removal rates.

The foregoing examples and description of the embodiments should be taken as illustrating, rather than as limiting the present invention as defined by the claims. As will be readily appreciated, numerous variations and combinations of the features set forth above can be utilized without departing from the present invention as set forth in the claims. Such variations are intended to be included within the scope of the following claims.

## Claims

1. A barrier chemical mechanical planarization polishing composition comprising:
≥ 15 wt.% of abrasive;
≤ 10 wt.% of chemical additive;
0.001 wt.% to 1.0 wt.% corrosion inhibitor,
water soluble solvent; wherein
the abrasive is selected from the group consisting of high purity colloidal silica, nano-sized colloidal silica, alumina, ceria, germania, silica, titania, zirconia, alumina dopes colloidal silica in lattices, and combinations thereof;
the chemical additive comprising at least one polyprotic acid or its salt selected from the group consisting of phosphonoacetic acid, its derivatives and their salts; phosphonic acid, its derivatives and their salts; phenylphosphonic acid, its derivatives and their salts; molybdenum diacid, its derivatives and their salts; oxalic acid, its derivatives and their salts; sulfurous acid, its derivative and their salts; arsenic acid, its derivatives and their salts; nitrobenzoic acid , its derivatives and their salts; malonic acid, its derivative and their salts;; silicic acid, its derivative and their salts; carbonic acid, its derivative and their salts; and combinations thereof, at least one polyprotic acid or its salt having more than one Pka and having Pka1 from 0 to 12;
the corrosion inhibitor is selected from the group consisting of benzotriazole, 3-amino-1, 2, 4-triazole, 3, 5-diamine-1, 2, 4-triazole, and combinations thereof
the water soluble solvent is selected from the group consisting of DI water, a polar solvent and a mixture of DI water and polar solvent; wherein the polar solvent is selected from the group consisting of alcohol, ether, ketone, or other polar reagent;
and wherein
the polishing composition has a pH of 2 to 12.

2. The barrier chemical mechanical planarization polishing composition of Claim 1, further comprising at least one of
second rate booster selected from the group consisting of nitrate salt and its derivatives; nitric salt and its derivatives; chloride salt and its derivatives; and combinations thereof;
surfactant selected from the group consisting of an acetylenic surfactant, an alcohol ethoxylate surfactant, and a combination thereof;
pH adjusting agent;
oxidizing agent; and
chelator.

3. The barrier chemical mechanical planarization polishing composition of Claim 1 or Claim 2, comprising:
≥ 2.4 wt.% of abrasive; and/or
≤ 5 wt.% of chemical additive.

4. The barrier chemical mechanical planarization polishing composition of any preceding claim, wherein the polishing composition has a pH of 4 to 12; and/or the chemical additive comprises at least one polyprotic acid or its salt having more than one Pka and having Pka1 from 0.5 to 10.

5. The barrier chemical mechanical planarization polishing composition of any preceding claim, wherein the abrasive; has a mean particle size of 10 nm to 300 nm.

6. The barrier chemical mechanical planarization polishing composition of any preceding claim, wherein the corrosion inhibitor is present in an amount of from 0.005 wt.% to 0.5 wt.%.

7. The barrier chemical mechanical planarization polishing composition of any preceding claim, wherein the composition further comprises at least one of:
the surfactant selected from the group consisting of an acetylenic diol surfactant, an alcohol ethoxylate surfactant, and a combination thereof; and the surfactant is present in an amount of from 0.001 wt. % to 1.0 wt.%;
the second rate booster selected from the group consisting of nitrate salt and its derivatives; nitric salt and its derivatives; chloride salt and its derivatives; acetate salt and its derivatives; and combinations thereof; and the second rate booster is used in an amount ranging from 0.05 wt. % to 5 wt.%;
the pH adjusting agent selected from the group consisting of a) nitric acid, sulfuric acid, tartaric acid, succinic acid, citric acid, malic acid, malonic acid, various fatty acids, various polycarboxylic acids and combinations thereof to lower pH of the polishing composition; and (b) potassium hydroxide, sodium hydroxide, ammonia, tetraethylammonium hydroxide, ethylenediamine, piperazine, polyethyleneimine, modified polyethyleneimine, and combinations thereof to raise pH of the polishing composition; and the pH adjusting agent is used in an amount ranging from 0.001 wt.% to 1 wt.%;
the oxidizing agent selected from the group consisting of hydrogen peroxide, periodic acid, potassium iodate, potassium permanganate, ammonium persulfate, ammonium molybdate, ferric nitrate, nitric acid, potassium nitrate, ammonia, amine compounds, and combinations thereof; and the oxidizing agent is used in an amount ranging from about 0.05 wt.% to about 5.0 wt.%; and
the chelator selected from the group consisting of organic acids and their salts; polymeric acids and their salts; water-soluble copolymers and their salts; copolymers and their salts containing at least two different types of acid groups selected from carboxylic acid groups; sulfonic acid groups; phosphoric acids; and pyridine acids in the same molecule of a copolymer; polyvinyl acids and their salts; polyethylene oxide; polypropylene oxide; pyridine, pyridine derivatives, bipyridine, bipyridine derivatives, and combinations thereof; and the chelator is used in an amount ranging from 0.05wt.% to about 5 wt.%.

8. The barrier chemical mechanical planarization polishing composition of any preceding claim, wherein the composition comprises silicon abrasive particles having a mean particle size of 15 nm to 200 nm; 0.025 wt.% to 4 wt.% of chemical additive selected from the group consisting of malonic acid, potassium sulfite, potassium molybdate, potassium silicate, potassium oxalate monohydrate, phosphonoacetic acid, and combinations thereof; an acetylenic diol surfactant or an alcohol ethoxylate surfactant; and water; wherein the composition has a pH of 6 to 11.

9. The barrier chemical mechanical planarization polishing composition of any preceding claim, wherein the composition comprises silicon abrasive particles having a mean particle size of 25 nm and 90 nm; 0.025 wt.% to 4 wt.% of chemical additive selected from the group consisting of malonic acid, potassium sulfite, potassium molybdate, potassium silicate, potassium oxalate monohydrate, phosphonoacetic acid, and combinations thereof; second rate booster selected from the group consisting of sodium silicate, ammonium silicate, tetramethylammonium silicate, tetrabutylammonium silicate, tetraethylammonium silicate, and combinations thereof; an acetylenic diol surfactant or an alcohol ethoxylate surfactant; and water; wherein the composition has a pH of 7 to 11.

10. The barrier chemical mechanical planarization polishing composition of any preceding claim, wherein the composition comprises silicon abrasive particles having a mean particle size of 25 nm and 90 nm; 0.025 wt.% to 4 wt.% of chemical additive having at least two selected from the group consisting of malonic acid, potassium sulfite, potassium molybdate, potassium silicate, potassium oxalate monohydrate, phosphonoacetic acid, and combinations thereof; second rate booster selected from the group consisting of sodium silicate, ammonium silicate, tetramethylammonium silicate, tetrabutylammonium silicate, tetraethylammonium silicate, and combinations thereof; an acetylenic diol surfactant or an alcohol ethoxylate surfactant; and water; wherein the composition has a pH of 7 to 11.

11. A polishing method for chemical mechanical planarization of a semiconductor device comprising at least one surface having at least a barrier layer and a dielectric layer; the method comprising the steps of:
providing the semiconductor device;
providing a polishing pad;
providing a polishing composition of any one of claims 1 to 10;
contacting the surface of the semiconductor substrate with the polishing pad and the chemical mechanical polishing composition; and
polishing the least one surface;
wherein the barrier layer comprises tantalum or titanium containing films selected from the group consisting of tantalum, tantalum nitride, tantalum tungsten silicon carbide, titanium, titanium nitride, titanium-tungsten, titanium tungsten nitride, and combinations thereof; and the dielectric layer selected from the group consisting of oxide film, low-K material, and combinations thereof.

12. The polishing method of claim 11, wherein the at least one surface comprises tantalum and tantalum nitride, and silicon dioxide.

13. A system for chemical mechanical planarization, comprising:
a semiconductor device comprising at least one surface having at least a barrier layer and a dielectric layer;
a polishing pad; and
a polishing composition of any one of claims 1 to 10; ;
wherein the barrier layer comprises tantalum or titanium containing films selected from the group consisting of tantalum, tantalum nitride, tantalum tungsten silicon carbide, titanium, titanium nitride, titanium-tungsten, titanium tungsten nitride, and combinations thereof; and the dielectric layer selected from the group consisting of oxide film, low-K material, and combinations thereof; and
the at least one surface is in contact with the polishing pad and the polishing composition.

14. The system of Claim 13, wherein the at least one surface comprises tantalum and tantalum nitride, and silicon dioxide.

## Patentansprüche

1. Chemisch-mechanische Planarisierungspolierzusammensetzung mit Barriere, die Folgendes umfasst:
≥ 1,5 Gew.-% Schleifmittel;
≤ 10 Gew.-% chemisches Additiv;
0,001 Gew.-% bis 1,0 Gew.-% Korrosionshemmstoff,
ein wasserlösliches Lösungsmittel; wobei
das Schleifmittel aus der Gruppe ausgewählt ist, die aus hochreinem kolloidalem Siliciumdioxid, nanoskaligem kolloidalem Siliciumdioxid, Aluminiumoxid, Cerdioxid, Germaniumdioxid, Siliciumdioxid, Titandioxid, Zirconiumdioxid, Aluminiumoxid dotiertem kolloidalem Siliciumdioxid in Gittern und Kombinationen davon besteht;
wobei das chemische Additiv wenigstens eine mehrwertige Säure oder ihr Salz umfasst, die aus der Gruppe ausgewählt sind, die aus Folgendem besteht:
Phosphonoessigsäure, ihren Derivaten und ihren Salzen;
Phosphonsäure, ihren Derivaten und ihren Salzen; Phenylphosphonsäure, ihren Derivaten und ihren Salzen; Molybdändisäure, ihren Derivate und ihren Salzen;
Oxalsäure, ihren Derivaten und ihren Salzen; schwefliger Säure, ihren Derivaten und ihren Salzen; Arsensäure, ihren Derivaten und ihren Salzen; Nitrobenzoesäure, ihren Derivaten und ihren Salzen; Malonsäure, ihren Derivaten und ihren Salzen; Kieselsäure, ihren Derivaten und ihren Salzen; Kohlensäure, ihren Derivaten und ihren Salzen; und Kombinationen davon, wobei wenigstens eine mehrwertige Säure oder ihr Salz mehr als einen Pka aufweisen und einen Pka1 von 0 bis 12 aufweisen;
der Korrosionshemmstoff aus der Gruppe ausgewählt ist, die aus Benzotriazol, 3-Amino-1,2,4-triazol, 3,5-Diamin-1,2,4-triazol und Kombinationen davon besteht;
das wasserlösliche Lösungsmittel aus der Gruppe ausgewählt ist, die aus DI-Wasser, einem polaren Lösungsmittel und einer Mischung aus DI-Wasser und dem polaren Lösungsmittel besteht; wobei das polare Lösungsmittel aus der Gruppe ausgewählt ist, die aus Alkohol, Ether, Keton oder einem anderen polaren Reagens besteht; und wobei
die Polierzusammensetzung einen pH-Wert von 2 bis 12 aufweist.

2. Chemisch-mechanische Planarisierungspolierzusammensetzung mit Barriere nach Anspruch 1, die ferner Folgendes umfasst:
einen zweitrangigen Booster, der aus der Gruppe ausgewählt ist, die aus Nitratsalz und seinen Derivaten; Salpetersalz und seinen Derivaten; Chloridsalz und seinen Derivaten; und Kombinationen davon besteht;
ein Tensid, das aus der Gruppe ausgewählt ist, die aus einem acetylenischen Tensid, einem Alkoholethoxylattensid und einer Kombination davon besteht;
ein pH-Wert-Einstellmittel;
ein Oxidationsmittel; und/oder
einen Chelatbildner.

3. Chemisch-mechanische Planarisierungspolierzusammensetzung mit Barriere nach Anspruch 1 oder 2, die Folgendes umfasst:
≥ 2,4 Gew.-% Schleifmittel; und/oder
≤ 5 Gew.-% chemisches Additiv.

4. Chemisch-mechanische Planarisierungspolierzusammensetzung mit Barriere nach einem der vorhergehenden Ansprüche, wobei die Polierzusammensetzung einen pH-Wert von 4 bis 12 aufweist; und/oder
das chemische Additiv wenigstens eine mehrwertige Säure oder ihr Salz umfasst, die mehr als einen Pka aufweisen und einen Pka1 von 0,5 bis 10 aufweisen.

5. Chemisch-mechanische Planarisierungspolierzusammensetzung mit Barriere nach einem der vorhergehenden Ansprüche, wobei das Schleifmittel eine mittlere Partikelgröße von 10 nm bis 300 nm aufweist.

6. Chemisch-mechanische Planarisierungspolierzusammensetzung mit Barriere nach einem der vorhergehenden Ansprüche, wobei der Korrosionshemmstoff in einer Menge von 0,005 Gew.-% bis 0,5 Gew.-% vorhanden ist.

7. Chemisch-mechanische Planarisierungspolierzusammensetzung mit Barriere nach einem der vorhergehenden Ansprüche, wobei die Zusammensetzung ferner Folgendes umfasst:
das Tensid, das aus der Gruppe ausgewählt ist, die aus einem Acetylendioltensid, einem Alkoholethoxylattensid und einer Kombination davon besteht; und das Tensid in einer Menge von 0,001 Gew.-% bis 1,0 Gew.-% vorhanden ist;
den zweitrangigen Booster, der aus der Gruppe ausgewählt ist, die aus Nitratsalz und seinen Derivaten; Salpetersalz und seinen Derivaten; Chloridsalz und seinen Derivaten; Acetatsalz und seinen Derivaten; und Kombinationen davon besteht; und der zweitrangige Booster in einer Menge in dem Bereich von 0,05 Gew.-% bis 5 Gew.-% verwendet wird;
das pH-Wert-Einstellmittel, das aus der Gruppe ausgewählt ist, die aus Folgendem besteht: (a) Salpetersäure, Schwefelsäure, Weinsäure, Bernsteinsäure, Citronensäure, Äpfelsäure, Malonsäure, diversen Fettsäuren, diversen Polycarbonsäuren und Kombinationen davon, um den pH-Wert der Polierzusammensetzung zu senken; und (b) Kaliumhydroxid, Natriumhydroxid, Ammoniak, Tetraethylammoniumhydroxid, Ethylendiamin, Piperazin, Polyethylenimin, modifiziertem Polyethylenimin und Kombinationen davon, um den pH-Wert der Polierzusammensetzung zu erhöhen; und das pH-Wert-Einstellmittel in einer Menge in dem Bereich von 0,001 Gew.-% bis 1 Gew.-% verwendet wird;
das Oxidationsmittel, das aus der Gruppe ausgewählt ist, die aus Wasserstoffperoxid, Periodsäure, Kaliumiodat, Kaliumpermanganat, Ammoniumpersulfat, Ammoniummolybdat, Eisen(III)-nitrat, Salpetersäure, Kaliumnitrat, Ammoniak, Aminverbindungen und Kombinationen davon besteht; und das Oxidationsmittel in einer Menge in dem Bereich von etwa 0,05 Gew.-% bis etwa 5,0 Gew.-% verwendet wird; und/oder
den Chelatbildner, der aus der Gruppe ausgewählt ist, die aus organischen Säuren und ihren Salzen; polymeren Säuren und ihren Salzen; wasserlöslichen Copolymeren und ihren Salzen; Copolymeren und ihren Salzen, die wenigstens zwei unterschiedliche Arten von Säuregruppen enthalten, ausgewählt aus Carbonsäuregruppen; Sulfonsäuregruppen; Phosphorsäuren; und Pyridinsäuren in demselben Molekül eines Copolymers; Polyvinylsäuren und ihren Salzen; Polyethylenoxid; Polypropylenoxid; Pyridin, Pyridinderivaten, Bipyridin, Bipyridinderivaten und Kombinationen davon besteht; und der Chelatbildner in einer Menge in dem Bereich von 0,05 Gew.-% bis etwa 5 Gew.-% verwendet wird.

8. Chemisch-mechanische Planarisierungspolierzusammensetzung mit Barriere nach einem der vorhergehenden Ansprüche, wobei die Zusammensetzung Siliciumschleifpartikel, die eine mittlere Partikelgröße von 15 nm bis 200 nm aufweisen; 0,025 Gew.-% bis 4 Gew.-% chemisches Additiv, das aus der Gruppe ausgewählt ist, die aus Malonsäure, Kaliumsulfit, Kaliummolybdat, Kaliumsilikat, Kaliumoxalatmonohydrat, Phosphonoessigsäure und Kombinationen davon besteht; ein Acetylendioltensid oder ein Alkoholethoxylattensid; und Wasser umfasst; wobei die Zusammensetzung einen pH-Wert von 6 bis 11 aufweist.

9. Chemisch-mechanische Planarisierungspolierzusammensetzung mit Barriere nach einem der vorhergehenden Ansprüche, wobei die Zusammensetzung Siliciumschleifpartikel, die eine mittlere Partikelgröße von 25 nm und 90 nm aufweisen; 0,025 Gew.-% bis 4 Gew.-% chemisches Additiv, das aus der Gruppe ausgewählt ist, die aus Malonsäure, Kaliumsulfit, Kaliummolybdat, Kaliumsilikat, Kaliumoxalatmonohydrat, Phosphonoessigsäure und Kombinationen davon besteht; den zweitrangigen Booster, der aus der Gruppe ausgewählt ist, die aus Natriumsilikat, Ammoniumsilikat, Tetramethylammoniumsilikat, Tetrabutylammoniumsilikat, Tetraethylammoniumsilikat und Kombinationen davon besteht; ein Acetylendioltensid oder ein Alkoholethoxylattensid; und Wasser umfasst; wobei die Zusammensetzung einen pH-Wert von 7 bis 11 aufweist.

10. Chemisch-mechanische Planarisierungspolierzusammensetzung mit Barriere nach einem der vorhergehenden Ansprüche, wobei die Zusammensetzung Siliciumschleifpartikel, die eine mittlere Partikelgröße von 25 nm und 90 nm aufweisen; 0,025 Gew.-% bis 4 Gew.-% chemisches Additiv, das wenigstens zwei aufweist, die aus der Gruppe ausgewählt sind, die aus Malonsäure, Kaliumsulfit, Kaliummolybdat, Kaliumsilikat, Kaliumoxalatmonohydrat, Phosphonoessigsäure und Kombinationen davon besteht; den zweitrangigen Booster, der aus der Gruppe ausgewählt ist, die aus Natriumsilikat, Ammoniumsilikat, Tetramethylammoniumsilikat, Tetrabutylammoniumsilikat, Tetraethylammoniumsilikat und Kombinationen davon besteht; ein Acetylendioltensid oder ein Alkoholethoxylattensid; und Wasser umfasst; wobei die Zusammensetzung einen pH-Wert von 7 bis 11 aufweist.

11. Polierverfahren für die chemisch-mechanische Planarisierung einer Halbleitervorrichtung, die wenigstens eine Oberfläche umfasst, die wenigstens eine Barriereschicht und eine dielektrische Schicht aufweist;
wobei das Verfahren die folgenden Schritte umfasst:
Bereitstellen der Halbleitervorrichtung;
Bereitstellen eines Polierkissens;
Bereitstellen einer Polierzusammensetzung nach einem der Ansprüche 1 bis 10;
Inberührungbringen der Oberfläche des Halbleitersubstrats mit dem Polierkissen und der chemisch-mechanischen Polierzusammensetzung; und
Polieren der wenigstens einen Oberfläche;
wobei die Barriereschicht tantal- oder titanhaltige Filme umfasst, die aus der Gruppe ausgewählt sind, die aus Tantal, Tantalnitrid, Tantalwolframsiliciumcarbid, Titan, Titannitrid, Titanwolfram, Titanwolframnitrid und Kombinationen davon besteht; und die dielektrische Schicht aus der Gruppe ausgewählt ist, die aus Oxidfilm, Material mit niedrigem K und Kombinationen davon besteht.

12. Polierverfahren nach Anspruch 11,
wobei die wenigstens eine Oberfläche Tantal und Tantalnitrid und Siliciumdioxid umfasst.

13. System für die chemisch-mechanische Planarisierung, das Folgendes umfasst:
eine Halbleitervorrichtung, die wenigstens eine Oberfläche umfasst, die wenigstens eine Barriereschicht und eine dielektrische Schicht aufweist;
ein Polierkissen; und
eine Polierzusammensetzung nach einem der Ansprüche 1 bis 10;
wobei die Barriereschicht tantal- oder titanhaltige Filme umfasst, die aus der Gruppe ausgewählt sind, die aus Tantal, Tantalnitrid, Tantalwolframsiliciumcarbid, Titan, Titannitrid, Titanwolfram, Titanwolframnitrid und Kombinationen davon besteht; und die dielektrische Schicht aus der Gruppe ausgewählt ist, die aus Oxidfilm, Material mit niedrigem K und Kombinationen davon besteht; und
wobei die wenigstens eine Oberfläche mit dem Polierkissen und der Polierzusammensetzung in Berührung steht.

14. System nach Anspruch 13,
wobei die wenigstens eine Oberfläche Tantal und Tantalnitrid und Siliciumdioxid umfasst.

## Revendications

1. Composition de polissage de planarisation mécano-chimique barrière comprenant :
≥ 1,5 % en poids d'abrasif ;
≤ 10 % en poids d'additif chimique ;
0,001 % en poids à 1,0 % en poids d'inhibiteur de corrosion,
un solvant hydrosoluble ;
l'abrasif étant choisi dans le groupe constitué de silice colloïdale de haute pureté, de silice colloïdale de taille nanométrique, d'alumine, de cérium, de germanium, de silice, de titane, de zircone, de dopes d'alumine, de silice colloïdale en réseaux et de leurs combinaisons ;
l'additif chimique comprenant au moins un acide polyprotique ou son sel choisi dans le groupe constitué de l'acide phosphonoacétique, de ses dérivés et de leurs sels ; d'acide phosphonique, de ses dérivés et de leurs sels ; d'acide phénylphosphonique, de ses dérivés et de leurs sels ; de diacide de molybdène, de ses dérivés et de leurs sels ;
d'acide oxalique, de ses dérivés et de leurs sels ; d'acide sulfureux, de ses dérivés et de leurs sels ; d'acide arsenique, de ses dérivés et de leurs sels ; d'acide nitrobenzoïque, de ses dérivés et de leurs sels ; d'acide malonique, de ses dérivés et de leurs sels ; d'acide silicique, de ses dérivés et de leurs sels ; d'acide carbonique, de ses dérivés et de leurs sels ; et de leurs combinaisons, au moins un acide polyprotique ou son sel ayant plus d'un Pka et ayant un Pka1 de 0 à 12 ;
l'inhibiteur de corrosion étant choisi dans le groupe constitué de benzotriazole, de 3-amino-1,2, de 4-triazole, de 3,5-diamine-1,2, de 4-triazole et de leurs combinaisons le solvant hydrosoluble étant choisi dans le groupe constitué d'eau DI, d'un solvant polaire et d'un mélange d'eau DI et de solvant polaire ; le solvant polaire étant choisi dans le groupe constitué d'alcool, d'éther, de cétone ou d'un autre réactif polaire ; et
la composition de polissage présentant un pH de 2 à 12.

2. Composition de polissage de planarisation mécano-chimique barrière selon la revendication 1, comprenant en outre
un second renforçateur de taux choisi dans le groupe constitué d'un sel de nitrate et de ses dérivés ; de sel nitrique et de ses dérivés ; de sel de chlorure et de ses dérivés ; et de leurs combinaisons ; et/ou
un tensioactif choisi dans le groupe constitué d'un tensioactif acétylénique, d'un tensioactif alcool éthoxylé et de leur combinaison ; et/ou
un agent d'ajustement du pH ; et/ou
un agent d'oxydation ; et/ou un chélateur.

3. Composition de polissage de planarisation mécano-chimique barrière selon la revendication 1 ou la revendication 2, comprenant :
≥ 2,4 % en poids d'abrasif ; et/ou
≤ 5 % en poids d'additif chimique.

4. Composition de polissage de planarisation mécano-chimique barrière selon l'une quelconque des revendications précédentes, dans laquelle la composition de polissage présente un pH de 4 à 12 ; et/ou l'additif chimique comprend au moins un acide polyprotique ou son sel ayant plus d'un Pka et ayant un Pka1 de 0,5 à 10.

5. Composition de polissage de planarisation mécano-chimique barrière selon l'une quelconque des revendications précédentes, dans laquelle l'abrasif a une granulométrie moyenne de 10 nm à 300 nm.

6. Composition de polissage de planarisation mécano-chimique barrière selon l'une quelconque des revendications précédentes, dans laquelle l'inhibiteur de corrosion est présent en une quantité de 0,005 % en poids à 0,5 % en poids.

7. Composition de polissage de planarisation mécano-chimique barrière selon l'une quelconque des revendications précédentes, dans laquelle la composition comprend en outre :
l'agent tensioactif choisi dans le groupe constitué d'un agent tensioactif diol acétylénique, d'un agent tensioactif éthoxylate alcool et de leur combinaison ; et le tensioactif est présent en une quantité de 0,001 % en poids à 1,0 % en poids ; et/ou
le second renforçateur de taux choisi dans le groupe constitué de sel de nitrate et de ses dérivés ; de sel nitrique et de ses dérivés ; de sel de chlorure et de ses dérivés ; de sel
d'acétate et de ses dérivés ; et de leurs combinaisons ; et le second renforçateur de taux est utilisé en une quantité allant de 0,05 % en poids à 5 % en poids ; et/ou
l'agent d'ajustement du pH choisi dans le groupe constitué a) d'acide nitrique, d'acide sulfurique, d'acide tartrique, d'acide succinique, d'acide citrique, d'acide malique, d'acide malonique, de divers acides gras, de divers acides polycarboxyliques et de leurs combinaisons pour réduire le pH de la composition de polissage ; et (b) d'hydroxyde de potassium, d'hydroxyde de sodium, d'ammoniac, d'hydroxyde de tétraéthylammonium, d'éthylènediamine, de pipérazine, de polyéthylèneimine, de polyéthylèneimine modifiée et
de leurs combinaisons pour élever le pH de la composition de polissage ; et l'agent d'ajustement du pH est utilisé en une quantité allant de 0,001 % en poids à 1 % en poids ; et/ou
l'agent oxydant choisi dans le groupe constitué de peroxyde d'hydrogène, d'acide périodique, d'iodate de potassium, de permanganate de potassium, de persulfate d'ammonium, de molybdate d'ammonium, de nitrate ferrique, d'acide nitrique, de nitrate de potassium, d'ammoniac, de composés aminés et de leurs combinaisons ; et l'agent oxydant est utilisé en une quantité allant d'environ 0,05 % en poids à environ 5,0 % en poids ; et/ou
le chélateur choisi dans le groupe constitué d'acides organiques et de leurs sels ; d'acides polymères et de leurs sels ; de copolymères hydrosolubles et de leurs sels ; de copolymères et de leurs sels contenant au moins deux types différents de groupes acides choisis parmi les groupes acides carboxyliques ; de groupes d'acides sulfoniques ;
d'acides phosphoriques ; et d'acides pyridiniques dans la même molécule d'un copolymère ; d'acides polyvinyliques et de leurs sels ; d'oxyde de polyéthylène ; d'oxyde de polypropylène ; de pyridine, de dérivés de pyridine, de bipyridine, de dérivés de bipyridine et de leurs combinaisons ; et le chélateur est utilisé en une quantité allant de 0,05 % en poids à environ 5 % en poids.

8. Composition de polissage de planarisation mécano-chimique barrière selon l'une quelconque des revendications précédentes, dans laquelle la composition comprend des particules abrasives de silicium ayant une granulométrie moyenne de 15 nm à 200 nm ; 0,025 % en poids à 4 % en poids d'un additif chimique choisi dans le groupe constitué d'acide malonique, de sulfite de potassium, de molybdate de potassium, de silicate de potassium, d'oxalate de potassium monohydraté, d'acide phosphonoacétique et de leurs combinaisons ; d'un tensioactif diol acétylénique ou d'un tensioactif alcool éthoxylé ; et d'eau ; la composition présentant un pH de 6 à 11.

9. Composition de polissage de planarisation mécano-chimique barrière selon l'une quelconque des revendications précédentes, dans laquelle la composition comprend des particules abrasives de silicium ayant une granulométrie moyenne de 25 nm et 90 nm ; 0,025 % en poids à 4 % en poids d'un additif chimique choisi dans le groupe constitué d'acide malonique, de sulfite de potassium, de molybdate de potassium, de silicate de potassium, d'oxalate de potassium monohydraté, d'acide phosphonoacétique et de leurs combinaisons ; d'un second renforçateur de taux choisi dans le groupe constitué de silicate de sodium, de silicate d'ammonium, de silicate de tétraméthylammonium, de silicate de tétrabutylammonium, de silicate de tétraéthylammonium et de leurs combinaisons ; d'un tensioactif diol acétylénique ou d'un tensioactif alcool éthoxylé ; et d'eau ; la composition présentant un pH de 7 à 11.

10. Composition de polissage de planarisation mécano-chimique barrière selon l'une quelconque des revendications précédentes, dans laquelle la composition comprend des particules abrasives de silicium ayant une granulométrie moyenne de 25 nm et 90 nm ; 0,025 % en poids à 4 % en poids d'additif chimique ayant au moins deux éléments choisis dans le groupe constitué d'acide malonique, de sulfite de potassium, de molybdate de potassium, de silicate de potassium, d'oxalate de potassium monohydraté, d'acide phosphonoacétique et de leurs combinaisons ; un second renforçateur de taux choisi dans le groupe constitué de silicate de sodium, de silicate d'ammonium, de silicate de tétraméthylammonium, de silicate de tétrabutylammonium, de silicate de tétraéthylammonium et de leurs combinaisons ; d'un tensioactif diol acétylénique ou d'un tensioactif alcool éthoxylé ; et d'eau ; la composition présentant un pH de 7 à 11.

11. Procédé de polissage pour la planarisation mécano-chimique d'un dispositif semi-conducteur comprenant au moins une surface ayant au moins une couche barrière et une couche diélectrique ;
le procédé comprenant les étapes suivantes :
la fourniture du dispositif semi-conducteur ;
la fourniture d'un tampon de polissage ;
la fourniture d'une composition de polissage selon l'une quelconque des revendications 1 à 10 ;
la mise en contact de la surface du substrat semi-conducteur avec le tampon de polissage et la composition de polissage mécano-chimique ; et
le polissage de l'au moins une surface ;
la couche barrière comprenant des films contenant du tantale ou du titane choisis dans le groupe constitué de tantale, de nitrure de tantale, de tantale tungstène, de carbure de silicium, de titane, de nitrure de titane, de titane-tungstène, de nitrure de tungstène titane et de leurs combinaisons ; et la couche diélectrique choisie dans le groupe constitué d'un film d'oxyde, d'un matériau à faible K et de leurs combinaisons.

12. Procédé de polissage selon la revendication 11,
l'au moins une surface comprenant du tantale et du nitrure de tantale et du dioxyde de silicium.

13. Système de planarisation mécano-chimique, comprenant :
un dispositif semi-conducteur comprenant au moins une surface ayant au moins une couche barrière et une couche diélectrique ;
un tampon de polissage ; et
la composition de planarisation chimico-mécanique selon l'une quelconque des revendications 1 à 10 ;
la couche barrière comprenant des films contenant du tantale ou du titane choisis dans le groupe constitué de tantale, de nitrure de tantale, de tantale tungstène, de carbure de silicium, de titane, de nitrure de titane, de titane-tungstène, de nitrure de tungstène titane et de leurs combinaisons ; et la couche diélectrique choisie dans le groupe constitué d'un film d'oxyde, d'un matériau à faible K et de leurs combinaisons ; et
au moins une couche d'oxyde étant en contact avec le tampon de polissage et la composition de polissage.

14. Système selon la revendication 13, l'au moins une surface comprenant du tantale et du nitrure de tantale et du dioxyde de silicium.
